# EUROPEAN PATENT APPLICATION

(11) **EP 4 807 133 A2**
(43) Date of publication of application: **16.09.2026**
(21) Application number: 26153500.9
(22) Date of filing: 22.01.2026
(51) Int. Cl.: E21B 47/00

(54) **RECALIBRATION TRIGGER FOR DOWNHOLE SURVEY SENSORS**

(30) Priority: 22.01.2025 US 202519034120
(71) Applicant: Services Pétroliers Schlumberger, 75007 Paris (FR); Schlumberger Technology B.V., 2514 JG The Hague (NL)
(72) Inventor: FLETT, Michael, Stonehouse, GL10 3SX (GB); MOUYIASIS, Michael, Stonehouse, GL10 3SX (GB); SHARMA, Varun, Katy, 77493 (US); SOERANGGAYOEDHA, Surapati, 34331 Dammam (SA)
(74) Representative: Schlumberger Intellectual Property Department

(57) **Abstract**

A method for determining a recalibration trigger for a downhole survey sensor includes obtaining historical calibration and recalibration data for a plurality of downhole survey sensors. The historical calibration data is evaluated to determine calibration changes for selected ones of the survey sensors. A probabilistic model is constructed from the determined calibration changes over a predetermined range of temperatures and benchmarked against at least one industry standard to estimate the recalibration trigger.

## Description

### CROSS REFERENCE TO RELATED APPLICATIONS

None.

### BACKGROUND

Wellbore attitude (inclination and azimuth) measurements are commonly made while drilling. Static survey measurements have long been made at a discrete number of longitudinal points along the axis of the wellbore when drilling has temporarily stopped and the drill string has been lifted off the bottom of the wellbore. More recently, methods have been developed to make continuous (dynamic) survey measurements in real time while drilling. These dynamic surveys have been a break-through in the drilling industry in that they significantly increase survey density and enable accurate surveys to be obtained while drilling.

Wellbore survey measurements (both static and dynamic) make use of tri-axial accelerometer measurements of the earth's gravitational field and tri-axial magnetometer measurements of the earth's magnetic field. In order to make survey measurements having suitable accuracy and precision, extensive calibration of the survey sensors is required, for example, to develop detailed thermal models for each sensor. Moreover, the sensors are commonly recalibrated at some fixed time or service interval to ensure an up to date and accurate calibration. While such sensor calibration procedures are commercially serviceable, they are time consuming and expensive and generally require that the survey tool be transported to and calibrated in a dedicated facility. There is a need in the industry for an improved sensor calibration protocol that provides a condition-based calibration trigger for downhole survey sensors and sensor modules.

### BRIEF DESCRIPTION OF THE DRAWINGS

For a more complete understanding of the disclosed subject matter, and advantages thereof, reference is now made to the following descriptions taken in conjunction with the accompanying drawings, in which:
FIG. 1 depicts a prior art drilling rig including a survey tool.
FIG. 2 depicts one example embodiment of the survey tool shown on FIG. 1.
FIG. 3 depicts a flow chart of an example method for determining a recalibration trigger for downhole survey sensors.
FIG. 4 depicts a flow chart of another example method for determining a recalibration trigger for downhole survey sensors.
FIG. 5A depicts an example probability density contour plotted versus pumping hours and sensor bias.
FIG. 5B depicts first, second, and third example vertical slices through the probability density contour shown on FIG. 5A.
FIGS. 5C, 5D, and 5E depict two-dimensional plots of certainty versus pumping hours corresponding to the first, second, and third slices shown on FIG. 5B.
FIGS. 6A and 6B (collectively FIG. 6) depict simulated probability density contours for accumulated shock (6A) and accumulated temperature (6B) environmental parameters.

### DETAILED DESCRIPTION

Methods and systems for determining a recalibration trigger for a downhole survey sensor are disclosed. One example method includes obtaining historical calibration and recalibration data for a plurality of downhole survey sensors. The historical calibration data is evaluated to determine calibration changes for selected ones of the survey sensors. A probabilistic model is constructed from the determined calibration changes over a predetermined range of temperatures and benchmarked against at least one industry standard to estimate the recalibration trigger.

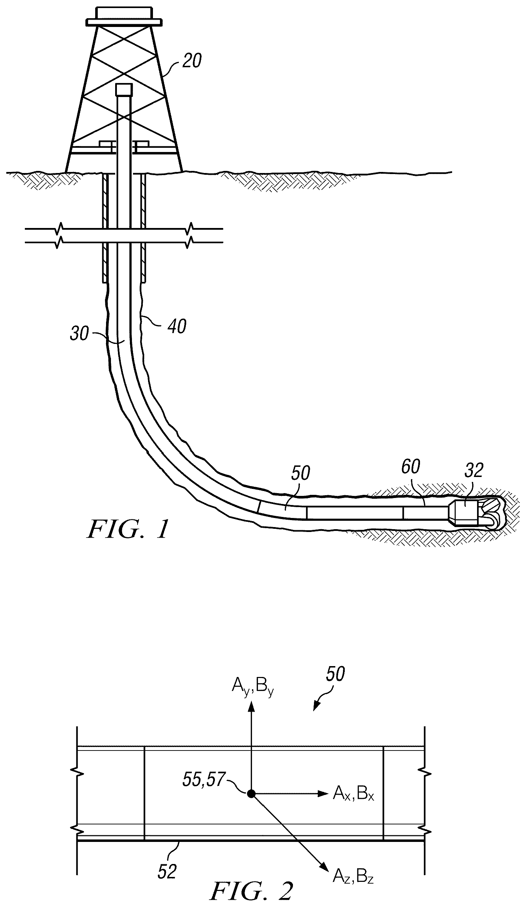

FIG. 1 depicts a drilling rig 20 including a drill string 30 and an example measurement while drilling (MWD) tool 50 and rotary steerable system (RSS) 60 deployed in the string 30 and disposed within a wellbore 40. The drilling rig 20 may be deployed onshore or offshore (an onshore application is depicted). As is known to those of ordinary skill, offshore rigs commonly include a platform deployed atop a riser that extends from the sea floor to the surface. The drill string extends downward from the platform, through the riser, and into the wellbore through a blowout preventer (BOP) located on the sea floor. The disclosed embodiments are not limited in these regards. In both onshore and offshore operations, the wellbore 40 may be drilled in the subterranean formations via rotary drilling, slide drilling, or power drilling in a manner that is well-known to those of ordinary skill in the art (e.g., via well-known directional drilling techniques).

In the illustrated embodiment, the MWD and RSS tools 50, 60 are commonly deployed in a bottom hole assembly (BHA) including other downhole tools. The BHA may further include, for example, a mud motor, a drill bit 32, and one or more logging while drilling (LWD) tools. Such LWD tools may be configured to measure various properties of the formation through which the wellbore penetrates, for example, including resistivity, NMR relaxation times, density, porosity, sonic velocity, gamma ray counts, and the like. Moreover, MWD tool 50 may be configured to measure one or more properties of the wellbore 40 as it is drilled or at any time thereafter. The physical properties may include, for example, pressure, temperature, wellbore caliper, wellbore trajectory (inclination and azimuth), a toolface angle, and the like. Suitable RSS tools 60 may also be configured to measure formation properties and/or wellbore properties.

It will, of course, be understood that the disclosed embodiments are not limited to any particular BHA configuration. Nor are they limited to any particular type of drilling operation. Moreover, it will be understood that wellbore surveying measurements (inclination and azimuth measurements) are commonly made in one or both of an MWD tool and a RSS tool. While the disclosed embodiments may be described in more detail below with respect to one or the other of MWD or RSS deployments, it will be appreciated that that the disclosed embodiments are not limited in this regard and that survey sensor modules may be deployed in MWD, LWD, and/or RSS tools.

FIG. 2 depicts a portion of the BHA including MWD tool 50. As depicted, the MWD tool 50 includes accelerometer 55 and magnetometer 57 sensor sets deployed in a tool collar 52. The depicted sensor sets may include tri-axial accelerometer and tri-axial magnetometer sensor sets, which may be any suitable commercially available devices known to those of ordinary skill. FIG. 2 further includes a diagrammatic representation of the tri-axial accelerometer and magnetometer sensor sets 55 and 57. By tri-axial it is meant that each sensor set includes three (or more) mutually perpendicular sensors, the accelerometers being designated as *Aₓ, A_{y},* and *A_{z}* and the magnetometers being designated as *Bₓ, B_{y},* and *B_{z}.* By convention, a right handed system is designated in which the x-axis accelerometer and magnetometer (*Aₓ* and *Bₓ*) are oriented substantially parallel with the tool axis (and therefore the wellbore axis) as indicated (although disclosed embodiments are not limited by such conventions). Each of the accelerometer and magnetometer sets may therefore be considered as determining a plane (the y and z-axes) and a pole (the x-axis along the axis of the BHA). The accelerometer and magnetometer sets may be referred to collectively herein as survey sensors.

As is known to those of ordinary skill, certain downhole survey sensors (particularly accelerometers) are highly sensitive to temperature changes. As a result, the survey sensors undergo extensive calibration, for example, to determine thermal model coefficients for each sensor prior to deployment in the field. Moreover, the survey sensors (or modules in which they are deployed) are commonly re-calibrated at some fixed time or service interval (such as every 1000 hours of pumping time) to ensure a valid and up to date calibration. As noted above in the Background section, such recalibration is time-consuming and requires dedicated off-site facilities. One aspect of the disclosed embodiments was the realization that at times (and in certain operational settings) the survey sensors may be re-calibrated less frequently without degrading survey accuracy or precision outside of acceptable limits.

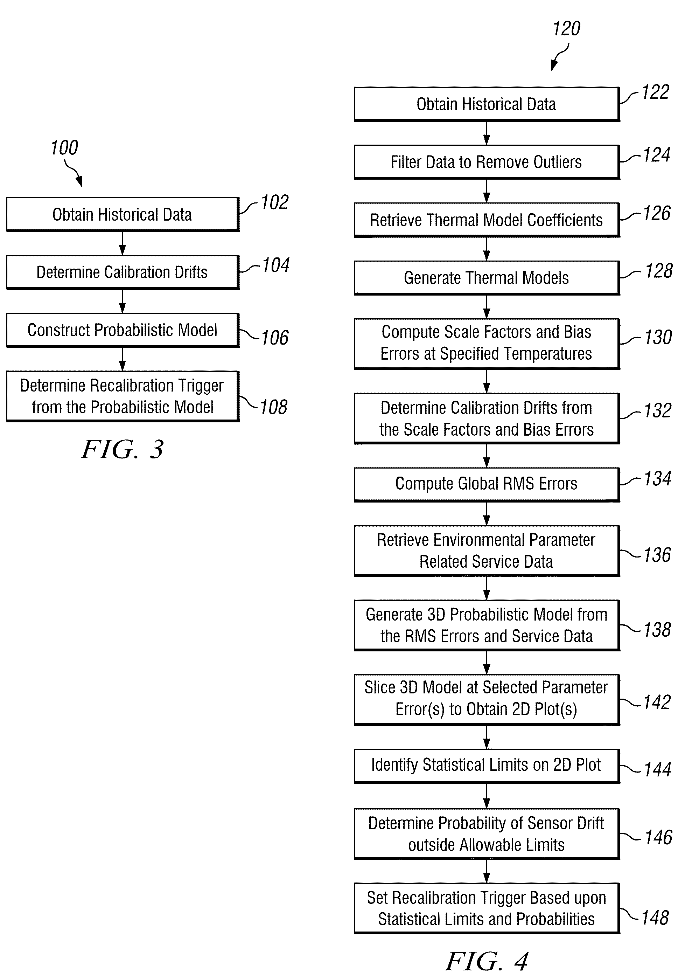

Turning now to FIG. 3, a flow chart of one disclosed method 100 for determining an appropriate recalibration trigger for downhole survey sensors is depicted. The method 100 includes obtaining historical calibration and recalibration data for each of a plurality of (e.g., a large number of such as 20 or more or 50 or more) survey sensors or sensor modules at 102. In advantageous embodiments, the historical data may be acquired from a fleet of survey tools and may include calibration and recalibration data for over 100 survey sensors (e.g., over 200, over 500, or even over 1000 survey sensors). The data is evaluated at 104 to determine calibration drifts (or changes to the calibration) for each sensor. For example, a first change may be determined between an initial calibration and a first recalibration, a second change may be determined between the first recalibration and the second recalibration, and so on. The determined calibration drifts may also be nonsequential, for example, a change between an initial calibration and a second recalibration or a change between a first recalibration and a fourth recalibration. The disclosed embodiments are not limited in this regard. A probabilistic model is constructed at 106 from the determined calibration drifts (or calibration changes), for example, from root mean square (RMS) errors for scale factor and bias errors for each sensor over a predetermined range of temperatures (e.g., from about 0 degrees C to about 250 degrees C). The probabilistic model is then evaluated and benchmarked against industry standards at 108 to estimate an optimum recalibration frequency or a recalibration trigger for the survey sensors (or a subset thereof).

With continued reference to FIG. 3, historical data generated during sensor calibrations may be obtained at 102, for example, on a server which may be localized or in the cloud (internet). The gathered data may be cleaned and/or filtered to remove outliers or other aberrant data. Thermal model coefficients may then be extracted from the gathered data and then compared across all calibrations for a given sensor package to estimate calibration drifts across the entire calibration temperature range (e.g., from about 0 degrees C to about 250 degrees C) at 104. A probabilistic model may be fit to the calibration drifts at 106 and used to benchmark sensor performance against the industry standards. The probabilistic model defines how frequently a sensor package should be re-calibrated based on usage variables such as service time since most recent calibration, service time below the rotary table, downhole pumping hours, general environmental exposure, accumulated vibration, accumulated time above a temperature threshold, and/or accumulated shock. Individual sensors may then be measured against these requirements at 108 to determine specific recalibration times, frequencies, or triggers.

FIG. 4 depicts a flow chart of another disclosed method 120 for determining an appropriate recalibration trigger for downhole survey sensors. The method 120 includes acquiring or gathering historical calibration and recalibration data for a large number of survey sensors or sensor modules at 122 (e.g., as described above with respect to FIG. 3). The data may be filtered at 124, for example, to remove outliers or sensor module data for which individual sensors have been replaced (e.g., owing to a failed sensor). Thermal model coefficients may be retrieved at 126 for the remaining sensor data (the data retained after filtering at 124). The coefficients may include, for example, polynomial coefficients for polynomial temperature calibration functions. The thermal models may then be generated from the retrieved model coefficients at 128 and used to compute scale factors and bias errors at specified temperature intervals for each of the sensors at 130. Calibration drifts (or changes to the calibration) for each sensor may be determined at 132 from the scale factors and biases computed at 130, for example, as described above. Global root mean square (RMS) errors may be computed at 134 for sensor scaling factor and bias errors for all sensors across a predetermine range of temperatures (e.g., across the entire calibration temperature range for each sensor) to obtain a probabilistic model of the sensor calibrations.

With continued reference to FIG. 4, environmental parameters upon which to trigger recalibrations may be retrieved at 136. These environmental parameters may include, for example, total downhole service time (such as pumping hours or hours below rotary table), accumulated temperature (such as hours above one or more temperature thresholds), and accumulated shock and/or vibrations (such as the total number of shocks above a threshold or hours above one or more vibrational thresholds). Retrieving the environmental parameters may further include retrieving corresponding service data from each of the sensor modules. For example, the service data may include total pumping hours or service hours, a temperature history, and/or shock and vibration history. The RMS errors computed at 134 may be input into a probability density function for one or more of the retrieved environmental parameters (e.g., pumping hours, accumulated temperature, accumulated shock and vibration, and/or etc.) to obtain corresponding three-dimensional probabilistic models at 138.

The 3D probability density function(s) may be sliced at 142 to obtain two-dimensional plots of the probability density (or certainty) versus the corresponding environmental parameter. For example, the slice may provide a two-dimensional plot of probability density versus pumping hours, or a two-dimensional plot of probability density versus accumulated temperature, or a plot of probability density versus accumulated shock. The slice may be taken at 142, for example, at industry standard limits (e.g., industry standard bias error limits) or other predetermined limits or calibration standards. The disclosed embodiments are not limited in this regard. The two-dimensional plots may be evaluated at 144 to identify statistical limits (e.g., one sigma limits indicative of one standard deviation) for each sensor parameter (e.g., bias). The two-dimensional slices may be further evaluated at 146 to determine the probability of sensors drifting outside of allowable limits. These probabilities may then be evaluated at 148 to set maximum acceptable environmental conditions and corresponding recalibration requirements. For example, the probabilities may be evaluated to set a maximum acceptable pumping hours requirement, or a maximum allowable accumulated temperature requirement, or a maximum allowable accumulated shock and vibration requirement. Individual sensors may then be measured against these requirements to determine specific recalibration times or frequencies.

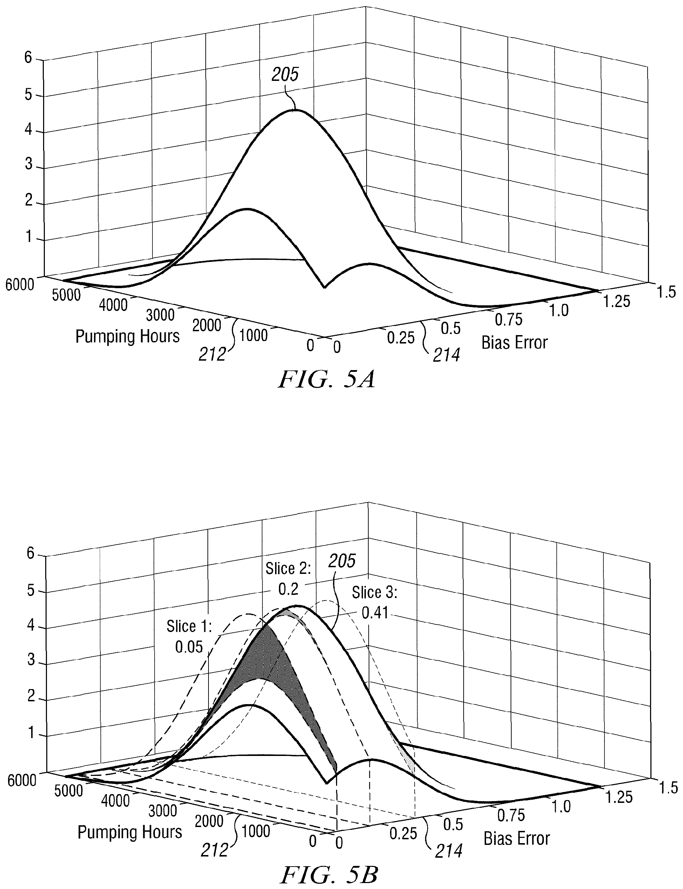

FIG. 5A depicts an example probability density contour 205 plotted versus pumping hours 212 and sensor bias 214. It will be appreciated that the depicted probability density function is merely an example and that in general the probability density function plots the probability density contour versus an environmental parameter (such as service hours, accumulated temperature, or accumulated shock and/or vibration) and a sensor calibration parameter (such as a scale factor or a bias).

FIG. 5B depicts three example two-dimensional slices through the probability density contour 205 shown on FIG. 5A. The first example slice 222 is made at a sensor bias (or error limit) of 0.05. The second example slice 224 is made at a sensor bias of 0.2. And the third example slice 226 is made at a sensor bias of 0.41.

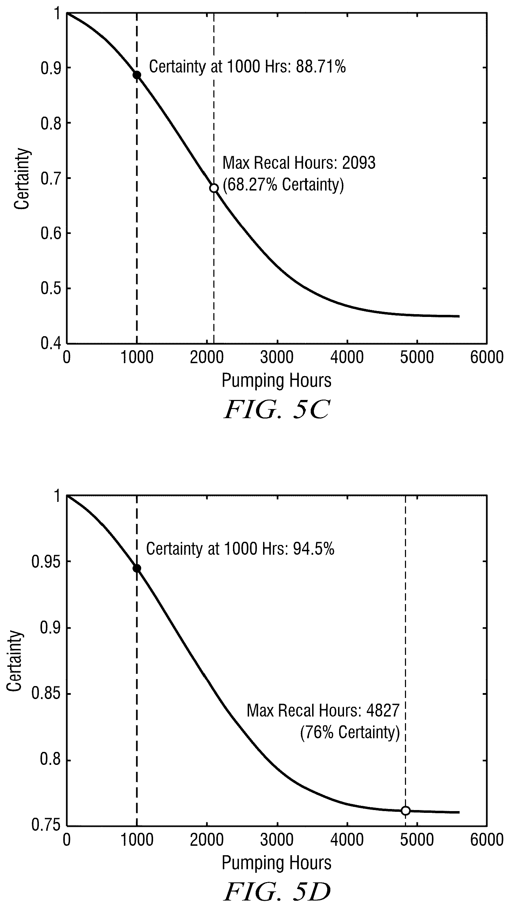

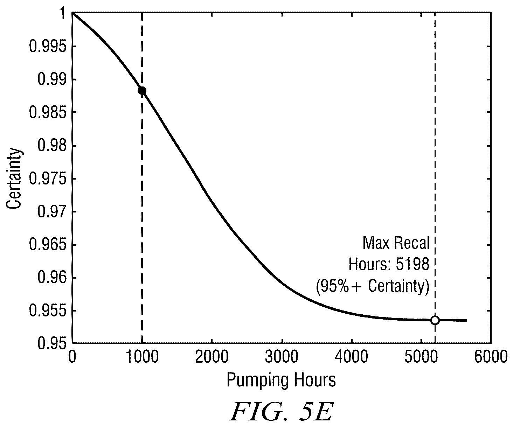

FIGS 5C, 5D, and 5E depict two-dimensional plots of certainty versus pumping hours at the error limits selected for corresponding slices 1 (5C), 2 (5D), and 3 (5E). In FIG. 5C, the certainty is about 89% at 1000 pumping hours when the error limit is selected to be 0.05 (slice 1). Moreover, a one-sigma maximum recall may be estimated at 2093 hours in this example. In FIG. 5D, the certainty is about 95% at 1000 pumping hours when the error limit is selected to be 0.2 (slice 2). The certainty remains above 75% at 5000 hours in this example. In FIG. 5E, the certainty is about 99% at 1000 pumping hours when the error limit is selected to be 0.45 (slice 3). The certainty remains above 95% at 5000 hours in this example.

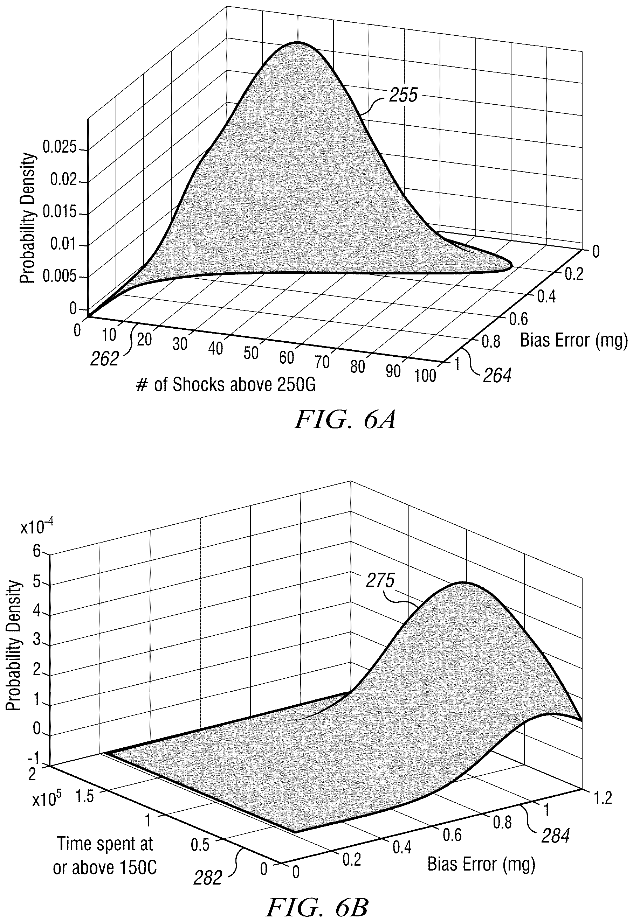

It will be appreciated that the depicted probability density function is merely an example and that in general the probability density function plots the probability density contour versus an environmental parameter (such as pumping hours, accumulated temperature, or accumulated shock and/or vibration) and a sensor calibration parameter (such as a scale factor or a bias). FIGS. 6A and 6B (collectively FIG. 6) depict example simulated probability density contours for accumulated shock (6A) and accumulated temperature (6B) environmental parameters. In FIG. 6A probability density contour 255 is plotted versus accumulated shocks above 250G 262 and sensor bias 264. In FIG. 6B probability density contour 275 is plotted versus accumulated time at a temperature greater than 150 degrees C 282 and sensor bias 284. It will be appreciated that one or more two-dimensional slices may also be extracted from the probability density functions shown on FIGS. 6A and 6B as described above with respect to FIG. 5.

It will be appreciated that the disclosed method embodiments may be implemented on a computer system. The computer system may include processor-readable or computer-readable program code embodying logic, including instructions for executing the method steps, for example, steps 102 through 108 in method 100 (FIG. 3) and/or steps 122 through 148 in method 120 (FIG. 4). The computer system may include one or more processors (e.g., microprocessors) which may be connected to one or more data storage devices (e.g., hard drives or solid state memory) and user interfaces as well as to the internet (or cloud). The disclosed embodiments are, of course, not limited to the use of or the configuration of any particular computer hardware and/or software.

It will be understood that the present disclosure includes numerous embodiments. These embodiments include, but are not limited to, the following embodiments.

In a first embodiment, a method for determining a recalibration trigger for a downhole survey sensor comprises obtaining historical calibration and recalibration data for a plurality of downhole survey sensors; evaluating the historical calibration data to determine calibration changes for selected ones of the plurality of survey sensors; constructing a probabilistic model from the determined calibration changes over a predetermined range of temperatures; and benchmarking the probabilistic model against at least one industry standard to estimate the recalibration trigger.

A second embodiment may include the first embodiment, wherein the historical calibration is obtained from a set of at least 20 survey sensors.

A third embodiment may include the any one of the first through second embodiments, further comprising removing outliers from the obtained historical calibration and recalibration data.

A fourth embodiment may include any one of the first through third embodiments, wherein the evaluating the historical calibration data further comprises retrieving thermal model coefficients from the historical calibration data; computing scale factors and bias errors at specified temperatures from the retrieved thermal model coefficients; and determining calibration changes from the computed scale factors and bias errors at the specified temperatures.

A fifth embodiment may include any one of the first through fourth embodiments, wherein the constructing the probabilistic model further comprises computing global root mean square errors for the scale factor and bias errors at the specified temperatures; retrieving environmental parameter related service data from the plurality of downhole survey sensors; and generating a probability density function including a three-dimensional probability density contour with respect to one of the environmental parameters and one of the scale factor or the bias error.

A sixth embodiment may include any one of the first through fifth embodiments, wherein the benchmarking the probabilistic model further comprises slicing the probability density function at a predetermined value for the scale factor or the bias error to obtain a two-dimensional plot of the probability density function versus the environmental parameter; identifying statistical limits for the scale factor or the bias error from the two-dimensional plot; and determining the recalibration trigger as a maximum acceptable value for the environmental parameter value from the identified statistical limits.

A seventh embodiment may include the sixth embodiment, wherein the identifying statistical limits further comprises determine a probability of a sensor drifting outside of allowable limits.

An eighth embodiment may include any one of the sixth through seventh embodiments, wherein the recalibration trigger is a maximum amount of downhole service time.

A ninth embodiment may include any one of the sixth through eighth embodiments, wherein the recalibration trigger is a maximum number of shocks above a threshold shock value.

A tenth embodiment may include any one of the sixth through ninth embodiments, wherein the recalibration trigger is a maximum amount of time in which the survey sensor is exposed to a temperature above a temperature threshold.

In an eleventh embodiment a system for determining a recalibration trigger for a downhole survey sensor comprises a downhole surveying tool including at least one downhole survey sensor; and a processor configured to: obtain historical calibration and recalibration data for a plurality of downhole survey sensors; evaluate the historical calibration data to determine calibration changes for selected ones of the plurality of survey sensors; construct a probabilistic model from the determined calibration changes over a predetermined range of temperatures; and benchmark the probabilistic model against at least one industry standard to estimate the recalibration trigger for the downhole survey sensor.

A twelfth embodiment may include the eleventh embodiment, wherein the evaluate the historical calibration data further comprises: retrieve thermal model coefficients from the historical calibration data; compute scale factors and bias errors at specified temperatures from the retrieved thermal model coefficients; and determine calibration changes from the computed scale factors and bias errors at the specified temperatures.

A thirteenth embodiment may include any one of the eleventh through twelfth embodiments, wherein the construct the probabilistic model further comprises: compute global root mean square errors for the scale factor and bias errors at the specified temperatures; retrieve environmental parameter related service data from the plurality of downhole survey sensors; and generate a probability density function including a three-dimensional probability density contour with respect to one of the environmental parameters and one of the scale factor or the bias error.

A fourteenth embodiment may include any one of the eleventh through thirteenth embodiments, wherein the benchmark the probabilistic model further comprises: slice the probability density function at a predetermined value for the scale factor or the bias error to obtain a two-dimensional plot of the probability density function versus the environmental parameter; identify statistical limits for the scale factor or the bias error from the two-dimensional plot; and determine the recalibration trigger as a maximum acceptable value for the environmental parameter value from the identified statistical limits.

A fifteenth embodiment may include any one of the eleventh through fourteenth embodiments, wherein the recalibration trigger is at least one of a maximum amount of downhole service time, a maximum number of shocks above a threshold shock value, and a maximum amount of time in which the survey sensor is exposed to a temperature above a temperature threshold.

In a sixteenth embodiment of a method of determining a recalibration trigger for a downhole survey sensor comprises obtaining historical calibration and recalibration data for a plurality of downhole survey sensors; retrieving thermal model coefficients from the historical calibration data for selected ones of the plurality of survey sensors; computing scale factors and bias errors at specified temperatures from the retrieved thermal model coefficients; determining calibration changes from the computed scale factors and bias errors at the specified temperatures; computing global root mean square errors for the scale factor and bias errors at the specified temperatures; retrieving environmental parameter related service data from the plurality of downhole survey sensors; generating a probability density function including a three-dimensional probability density contour with respect to one of the environmental parameters and one of the scale factor and the bias error; slicing the probability density function at a predetermined value for the scale factor or the bias error to obtain a two-dimensional plot of the probability density function versus the environmental parameter; identifying statistical limits for the scale factor or the bias error from the two-dimensional plot; and determining the recalibration trigger as a maximum acceptable value for the environmental parameter from the identified statistical limits.

A seventeenth embodiment may include the sixteenth embodiment, wherein the historical calibration is obtained from a set of at least 20 survey sensors.

An eighteenth embodiment may include any one of the sixteenth through seventeenth embodiments, wherein the recalibration trigger is a maximum amount of downhole service time.

A nineteenth embodiment may include any one of the sixteenth through eighteenth embodiments, wherein the recalibration trigger is a maximum number of shocks above a threshold shock value.

A twentieth embodiment may include any one of the sixteenth through nineteenth embodiments, wherein the recalibration trigger is a maximum amount of time in which the survey sensor is exposed to a temperature above a temperature threshold.

Although a recalibration trigger for downhole survey sensors has been described in detail, it should be understood that various changes, substitutions and alternations can be made herein without departing from the spirit and scope of the disclosure as defined by the appended claims.

## Claims

1. A method for determining a recalibration trigger for a downhole survey sensor, the method comprising:
obtaining historical calibration and recalibration data for a plurality of downhole survey sensors;
evaluating the historical calibration data to determine calibration changes for selected ones of the plurality of survey sensors;
constructing a probabilistic model from the determined calibration changes over a predetermined range of temperatures; and
benchmarking the probabilistic model against at least one industry standard to estimate the recalibration trigger.

2. The method of claim 1, wherein the historical calibration is obtained from a set of at least 20 survey sensors.

3. The method of claim 1 or 2, further comprising removing outliers from the obtained historical calibration and recalibration data.

4. The method of any one of the preceding claims, wherein the evaluating the historical calibration data further comprises:
retrieving thermal model coefficients from the historical calibration data;
computing scale factors and bias errors at specified temperatures from the retrieved thermal model coefficients; and
determining calibration changes from the computed scale factors and bias errors at the specified temperatures.

5. The method of any one of the preceding claims, wherein the constructing the probabilistic model further comprises:
computing global root mean square errors for the scale factor and bias errors at the specified temperatures;
retrieving environmental parameter related service data from the plurality of downhole survey sensors; and
generating a probability density function including a three-dimensional probability density contour with respect to one of the environmental parameters and one of the scale factor or the bias error.

6. The method of any one of the preceding claims, wherein the benchmarking the probabilistic model further comprises:
slicing the probability density function at a predetermined value for the scale factor or the bias error to obtain a two-dimensional plot of the probability density function versus the environmental parameter;
identifying statistical limits for the scale factor or the bias error from the two-dimensional plot; and
determining the recalibration trigger as a maximum acceptable value for the environmental parameter value from the identified statistical limits.

7. The method of claim 6, wherein the identifying statistical limits further comprises determine a probability of a sensor drifting outside of allowable limits.

8. A system for determining a recalibration trigger for a downhole survey sensor, the system comprising:
a downhole surveying tool including at least one downhole survey sensor;
a processor configured to:
obtain historical calibration and recalibration data for a plurality of downhole survey sensors;
evaluate the historical calibration data to determine calibration changes for selected ones of the plurality of survey sensors;
construct a probabilistic model from the determined calibration changes over a predetermined range of temperatures; and
benchmark the probabilistic model against at least one industry standard to estimate the recalibration trigger for the downhole survey sensor.

9. The system of claim 8, wherein the evaluate the historical calibration data further comprises:
retrieve thermal model coefficients from the historical calibration data;
compute scale factors and bias errors at specified temperatures from the retrieved thermal model coefficients; and
determine calibration changes from the computed scale factors and bias errors at the specified temperatures.

10. The system of claim 8 or 9, wherein the construct the probabilistic model further comprises:
compute global root mean square errors for the scale factor and bias errors at the specified temperatures;
retrieve environmental parameter related service data from the plurality of downhole survey sensors; and
generate a probability density function including a three-dimensional probability density contour with respect to one of the environmental parameters and one of the scale factor or the bias error.

11. The system of any one of the claims 8 - 10, wherein the benchmark the probabilistic model further comprises:
slice the probability density function at a predetermined value for the scale factor or the bias error to obtain a two-dimensional plot of the probability density function versus the environmental parameter;
identify statistical limits for the scale factor or the bias error from the two-dimensional plot; and
determine the recalibration trigger as a maximum acceptable value for the environmental parameter value from the identified statistical limits.

12. A method determining a recalibration trigger for a downhole survey sensor, the method comprising:
obtaining historical calibration and recalibration data for a plurality of downhole survey sensors;
retrieving thermal model coefficients from the historical calibration data for selected ones of the plurality of survey sensors;
computing scale factors and bias errors at specified temperatures from the retrieved thermal model coefficients;
determining calibration changes from the computed scale factors and bias errors at the specified temperatures;
computing global root mean square errors for the scale factor and bias errors at the specified temperatures;
retrieving environmental parameter related service data from the plurality of downhole survey sensors;
generating a probability density function including a three-dimensional probability density contour with respect to one of the environmental parameters and one of the scale factor and the bias error;
slicing the probability density function at a predetermined value for the scale factor or the bias error to obtain a two-dimensional plot of the probability density function versus the environmental parameter;
identifying statistical limits for the scale factor or the bias error from the two-dimensional plot; and
determining the recalibration trigger as a maximum acceptable value for the environmental parameter from the identified statistical limits.

13. The method of claim 12, wherein the recalibration trigger is a maximum amount of downhole service time.

14. The method of claim 12 or 13, wherein the recalibration trigger is a maximum number of shocks above a threshold shock value.

15. The method of any one of the claims 12 - 14, wherein the recalibration trigger is a maximum amount of time in which the survey sensor is exposed to a temperature above a temperature threshold.
